# EUROPEAN PATENT APPLICATION

(11) **EP 2 591 913 A1**
(43) Date of publication of application: **15.05.2013**
(21) Application number: 11819877.9
(22) Date of filing: 22.08.2011
(51) Int. Cl.: B32B 27/32, H01L 31/042

(54) **TRANSPARENT PROTECTIVE SHEET AND SOLAR CELL MODULE USING SAME**

(30) Priority: 23.08.2010 JP 2010186360
(71) Applicant: LINTEC Corporation, Tokyo 173-0001 (JP)
(72) Inventor: NISHIDA Takuo, Tokyo 173-0001 (JP)
(74) Representative: Jansen, Cornelis Marinus
(86) International application number: PCT/JP2011/068841
(87) International publication number: WO 2012/026414

(57) **Abstract**

Provided is a transparent protective sheet (10) including a supporting base sheet (11), and a thermally fusible resin layer (12) that is laminated on at least one surface (11a) of the supporting base sheet (11). The thermally fusible resin layer (12) is formed from a copolymer obtained by polymerizing ethylene and an unsaturated carboxylic acid as essential components, and a content ratio of a constituent unit derived from the unsaturated carboxylic acid is 5 to 30% by mass. According to the invention, a transparent protective sheet of which the transparency does not deteriorate due to a heating treatment, and a solar cell module using the transparent protective sheet are provided.

## Description

### Technical Field

The present invention relates to a transparent protective sheet that is used as a front surface protective sheet or a rear surface protective sheet of a solar cell module, or the like, and a solar cell module using the same.
Priority is claimed on Japanese Patent Application No. 2010-186360, filed August 23, 2010, the content of which is incorporated herein by reference.

### Background Art

A solar cell module that converts the light energy of the sun to electric energy has attracted attention as a clean energy source that is capable of performing power generation without discharging carbon dioxide with respect to environmental problems such as atmospheric pollution and global warming.
The solar cell module schematically includes a solar cell that performs photoelectric conversion, a sealing material that seals the solar cell and is formed from an electrical insulator, and protective sheet that is laminated on the front surface side and the rear surface side of the solar cell, respectively.
This solar cell module is manufactured by sequentially laminating the sealing material and a front surface protective sheet on the front surface side of the solar cell, sequentially laminating the sealing material and a rear surface protective sheet on the rear surface side of the solar cell, and then heating and pressing the resultant laminated body in a vacuum chamber to integrate the respective components of the laminated body.

As the rear surface protective sheet for the solar cell module, a sheet, which is obtained by laminating a thermally fusible resin layer on a sealing material side surface of a polyester base material having hydrolysis resistance, is known. The thermally fusible resin layer includes, as a main component, any one kind selected from ethylene-(meth)acrylic acid ester copolymer and ethylene-vinyl acetate copolymer that are graft-modified from any one of an epoxy compound, a silane compound, and a compound of these two kinds, and a mixture of these copolymers (for example, refer to PTL 1).

### Citation List

### Patent Literature

[PTL 1] Japanese Unexamined Patent Application, First Publication No. 2008-108947

### Summary of Invention

### Technical Problem

In regard to the above-described rear surface protective sheet for the solar cell module, large spherulites may be generated in the thermally fusible resin layer in a process of heating and pressing the laminated body including the solar cell sealing material and the protective sheet. As described above, when the large spherulites are generated in the thermally fusible resin layer, since the spherulites scatter light, there is a problem in that the transparency of the protective sheet deteriorates.

The invention has been made in consideration of the above-described circumstances, and an object thereof is to provide a transparent protective sheet of which transparency does not deteriorate due to a heating treatment, and a solar cell module using the transparent protective sheet.

### Solution to Problem

According to a first aspect of the invention, there is provided a transparent protective sheet including a supporting base sheet, and a thermally fusible resin layer that is laminated on at least one surface of the supporting base sheet, wherein the thermally fusible resin layer is formed from a copolymer obtained by polymerizing ethylene and an unsaturated carboxylic acid as essential components, and a content ratio of a constituent unit derived from the unsaturated carboxylic acid is 5 to 30% by mass.

In the transparent protective sheet, it is preferable that a haze value after the heating treatment be 5% or less.

In the transparent protective sheet, it is preferable that the unsaturated carboxylic acid be an acrylic acid or methacrylic acid.

In the transparent protective sheet, it is preferable that a thickness of the thermally fusible resin layer be within a range of 1 to 200 µm.

The transparent protective sheet may further include a deposited layer, and it is preferable that the deposited layer be laminated on the surface of the supporting base sheet on which the thermally fusible resin layer is provided.

The transparent protective sheet may further include a fluorine resin layer, and it is preferable that the fluorine resin layer be laminated on a surface opposite to the surface of the supporting base sheet on which the thermally fusible resin layer is formed.

According to a second aspect of the invention, there is provided a solar cell module including a solar cell, a sealing material that seals the solar cell, and a transparent protective sheet that is laminated on the sealing material, wherein the transparent protective sheet is formed from the transparent protective sheet of the invention, and the transparent protective sheet is laminated on the sealing material through the thermally fusible resin layer.

### Advantageous Effects of Invention

According to the transparent protective sheet of the invention, since the thermally fusible resin layer is formed from a copolymer obtained by polymerizing ethylene and an unsaturated carboxylic acid as essential components, and a content ratio of a constituent unit derived from the unsaturated carboxylic acid is 5 to 30% by mass, it is possible to suppress generation of large spherulites in the thermally fusible resin layer due to a heating treatment for integrating the laminated body including the solar cell, the sealing material, and the transparent protective sheet. Accordingly, a light scattering phenomenon in the thermally fusible resin layer is suppressed, and thus an increase in haze is suppressed. Furthermore, it is possible to prevent transparency of the thermally fusible resin layer from deteriorating.

### Brief Description of Drawings

FIG. 1 is a schematic cross-sectional diagram illustrating a first embodiment of a transparent protective sheet of the invention.
FIG. 2 is a schematic cross-sectional diagram illustrating a second embodiment of the transparent protective sheet of the invention.
FIG. 3 is a schematic cross-sectional diagram illustrating a third embodiment of the transparent protective sheet of the invention.
FIG. 4 is a schematic cross-sectional diagram illustrating an embodiment of a solar cell module of the invention.

### Description of Embodiments

Embodiments of a transparent protective sheet of the invention, and a solar cell module using the transparent protective sheet will be described.
In addition, the embodiments are described in detail for better understanding of the gist of the invention, and although not particularly designated, the invention is not limited to the embodiments.

### (1) First Embodiment

### "Transparent Protective Sheet"

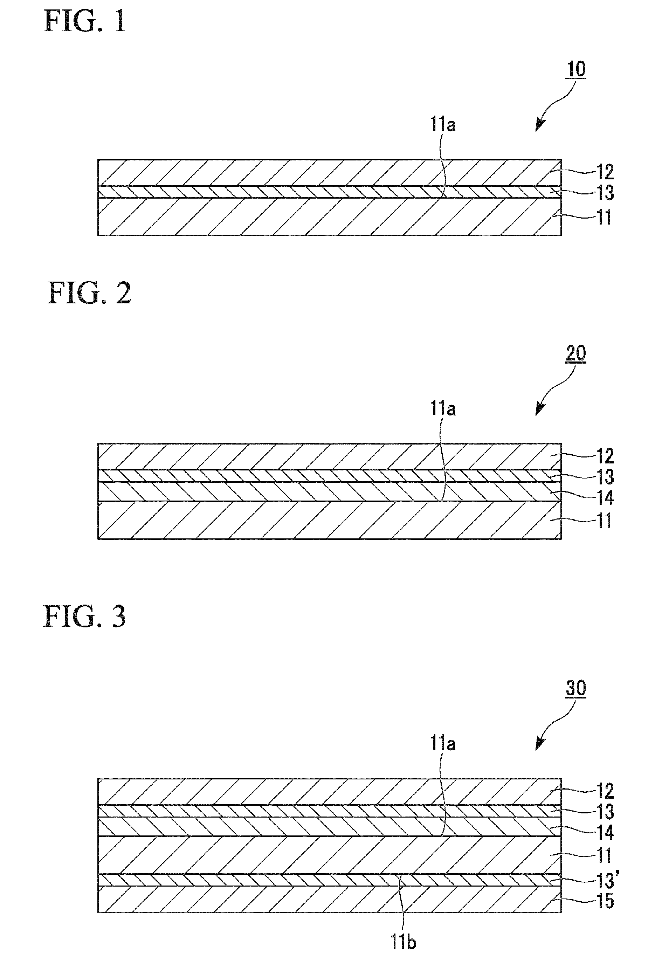

FIG. 1 shows a schematic cross-sectional diagram illustrating a first embodiment of a transparent protective sheet of the invention.
The transparent protective sheet 10 of this embodiment schematically includes a supporting base sheet 11, and a thermally fusible resin layer 12 that is laminated on one surface 11a of the supporting base sheet 11 through an adhesive layer 13.
The transparent protective sheet 10 is applied to a front surface protective sheet (front sheet) or a rear surface protective sheet (back sheet) of the solar cell module.

As the supporting base sheet 11, a resin sheet is used that has electrical insulation properties and on which the thermally fusible resin layer 12 may be laminated.

As a resin sheet that is used for the supporting base sheet 11, a resin sheet is selected which is generally used as a supporting base sheet in a protective sheet for a solar cell module.
Examples of the resin sheet that is used for the supporting base sheet 11 include sheets of a stretched film or a non-stretched film that is obtained by forming a film using a polymer such as polypropylene, polystyrene, polymethyl methacrylate, polytetrafluoroethylene, polyamide (nylon 6, nylon 66), polyacrylonitrile, polyvinyl chloride, polyethylene terephthalate (PET), polybutylene terephthalate (PBT), polyethylene naphthalate (PEN), polyoxymethylene, polycarbonate, polyphenylene oxide, polyester urethane, poly(m-phenylene isophthalamide), or poly(p-phenylene isophthalamide).
Among these resin sheets, a sheet formed from polyester such as PET, PBT, and PEN is preferable from the viewpoints of electrical insulation properties, heat resistance, chemical resistance, dimensional stability, and a formability are satisfactory, and more specifically, the PET sheet is appropriate.

The thickness of the supporting base sheet 11 is appropriately selected on the basis of the electrical insulation property that is required in the solar cell module, and commonly, the thickness is preferably within in a range of 10 to 400 µm. More specifically, in a case where the supporting base sheet 11 is formed from the PET sheet, from viewpoints of lightness and an electrical insulation property, it is preferable that the thickness be within a range of 20 to 350 µm, more preferably within a range of 50 to 300 µm, and still more preferably within a range of 100 to 250 µm.

In addition, various additives, which do not deteriorate transparency, adhesiveness, weather resistance, and the like, may be added to the supporting base sheet 11.
Examples of the additives include an ultraviolet absorbing agent, an antioxidant, and the like.

The thermally fusible resin layer 12 is formed from a copolymer obtained by polymerizing ethylene and an unsaturated carboxylic acid as essential components, and a content ratio of a constituent unit derived from the unsaturated carboxylic acid is 5 to 30% by mass. The thermally fusible resin layer 12 forms an adhesive layer that is used for adhesion with the sealing material making up the solar cell module. The constituent unit represents a monomer unit making up the polymer (resin).
Examples of the unsaturated carboxylic acid include an acrylic acid, a methacrylic acid, a maleic acid, and the like, and particularly, the acrylic acid or the methacrylic acid is preferable.

When the thermally fusible resin layer 12 is laminated on one surface 11a of the supporting base sheet 11 as an outermost layer of the transparent protective sheet 10, the transparent protective sheet 10 may be adhered to an external surface of a sealing material making up the solar cell module. The thermally fusible resin layer 12 may be adhered to the sealing material of the transparent protective sheet by a heating and pressing treatment within a range of 50 to 200°C, and thus may be strongly adhered to the sealing material.

In the thermally fusible resin layer 12, ethylene·(meth)acrylic acid ester may be further copolymerized.
Here, the (meth)acrylic acid ester represents acrylic acid ester or methacrylic acid ester, and examples of the (meth)acrylic acid ester include (meth)acrylic acid methyl, (meth)acrylic acid ethyl, (meth) acrylic acid propyl, (meth) acrylic acid butyl, and the like.

In addition, in the invention, in the copolymer obtained by polymerizing ethylene and an unsaturated carboxylic acid as essential components, the content ratio of the constituent unit derived from the unsaturated carboxylic acid is 5 to 30% by mass. However, it is preferable that the content ratio be 9 to 20% by mass, and more preferably 9 to 15% by mass.
When the content ratio of the constituent unit derived from the unsaturated carboxylic acid is less than 5% by mass, haze of the thermally fusible resin layer 12 increases. On the other hand, when the content ratio of the constituent unit derived from the unsaturated carboxylic acid exceeds 30% by mass, since the melt flow rate becomes high, it is difficult to form the thermally fusible resin layer 12.

In addition, when constructing the thermally fusible resin layer 12, various additives may be blended as long as the additives do not deteriorate transparency, adhesiveness, weather resistance, and the like.
Examples of the additives include a neutralizing agent, a lubricant, an ultraviolet absorbing agent, an antioxidant, and the like.
Examples of the neutralizing agent include calcium stearate, zinc stearate, magnesium stearate, and the like.
Examples of the lubricant include erucic acid amide, oleic acid amide, stearic acid amide, behenic acid amide, ethylenebisstearic acid amide, ethylenebisoleic acid amide, stearyl erucamide, oleyl palmitic amide, and the like.

The thickness of the thermally fusible resin layer 12 is appropriately adjusted in accordance with the supporting base sheet 11 and the sealing material of the solar cell module. For example, it is preferable that the thickness of the thermally fusible resin layer 12 be within a range of 1 to 200 µm. From viewpoints of lightness, an electrical insulation property, and the like, it is more preferable that the thickness be within a range of 10 to 200 µm, still more preferably within a range of 50 to 150 µm, and still more preferably within a range of 80 to 120 µm.

As the adhesive making up the adhesive layer 13, a urethane-based adhesive is used.
In the invention, the urethane-based adhesive represent an adhesive resin that is cured by a reaction between an isocyanate compound and a polyol compound, and has a urethane bond.
Examples of the polyol that is used for the urethane-based resin include polyester polyol, polycarbonate polyol, acrylic polyol, and the like.

The polyester polyol used in the urethane-based adhesive is obtained by causing a dibasic acid to react with a diol.
Examples of the aliphatic dibasic acid include succinic acid, glutaric acid, adipic acid, pimelic acid, suberic acid, azelaic acid, sebacic acid, and brassylic acid.
Examples of the aromatic dibasic acid include isophthalic acid, terephthalic acid, and naphthalene dicarboxylic acid.

Examples of the diol component include an aliphatic diol component, an alicyclic diol component, and an aromatic diol component.
Examples of the aliphatic diol include ethylene glycol, propylene glycol, butane diol, neopentyl glycol, methyl pentane diol, hexane diol, heptane diol, octane diol, nonane diol, decane diol, and dodecane diol.
Examples of the alicyclic diol include cyclohexane diol and hydrogenated xylene glycol.
Examples of the aromatic diol include xylene glycol.

These dibasic acid components and diol components may be used alone or in combination of two or more kinds thereof, respectively.

Furthermore, examples of the polyester polyol include polyester urethane polyols in which both the hydroxyl groups at the ends of the polyester polyol are chain-elongated with a single isocyanate compound selected from 2,4-tolylene diisocyanate, 2,6-tolylene diisocyanate, xylene diisocyanate, 4,4'-diphenylmethane diisocyanate, methylene diisocyanate, isopropylene diisocyanate, lysine diisocyanate, 2,2,4-trimethylhexamethylene diisocyanate, 2,4,4-trimethylhexamethylene diisocyanate, 1,6-hexamethylene diisocyanate, methylcyclohexane diisocyanate, isophorone diisocyanate, 4,4-dicyclohexylmethane diisocyanate, isopropylidene dicyclohexyl-4,4-diisocyanate, and the like, and adducts, biurets, or isocyanurates of the isocyanate compounds selected from at least one or more kinds thereof.

The polycarbonate polyol used in the urethane-based adhesive is obtained by causing a carbonate compound to react with a diol.
Examples of the carbonate compound include dimethyl carbonate, diphenyl carbonate, and ethylene carbonate.
Examples of the diol include an aliphatic diol, an alicyclic diol, and an aromatic diol.

Examples of the aliphatic diol include ethylene glycol, propylene glycol, butane diol, neopentyl glycol, methyl pentane diol, hexane diol, heptane diol, octane diol, nonane diol, decane diol, and dodecane diol.
Examples of the alicyclic diol include cyclohexane diol and hydrogenated xylene glycol.
Examples of the aromatic diol include xylene glycol.

In addition, as the polycarbonate polyol, polycarbonate polyols formed with a mixture of one or more kinds of the diols above are used, or polycarbonate urethane polyols which are chain-elongated with the isocyanate compounds above are used.

As the acrylic polyol used in the urethane-based adhesive, those having hydroxy group-containing monomers such as 2-hydroxyethyl (meth)acrylate and 2-hydroxypropyl (meth)acrylate as essential constituent components and having (meth)acrylic acid or alkyl (meth)acrylate monomers as main constituent components are used.

Examples of the alkyl group constituting the alkyl (meth)acrylate monomers include a methyl group, an ethyl group, an n-propyl group, an i-propyl group, an n-butyl group, an i-butyl group, a t-butyl group, a 2-ethylhexyl group, and a cyclohexyl group.

Furthermore, as the acrylic polyol, acrylic polyols obtained by copolymerizing amide group-containing monomers, glycidyl group-containing monomers, or the like are used.

Examples of the amide group-containing monomers include (meth)acrylamide, N-alkyl (meth)acrylamide, N,N-dialkyl (meth)acrylamide (in which examples of the alkyl group include a methyl group, an ethyl group, an n-propyl group, an i-propyl group, an n-butyl group, an i-butyl group, a t-butyl group, a 2-ethylhexyl group, and a cyclohexyl group), N-alkoxy (meth)acrylamide, N,N-dialkoxy (meth)acrylamide (in which examples of the alkoxy group include a methoxy group, an ethoxy group, a butoxy group, and an isobutoxy group), N-methylol (meth)acrylamide, and N-phenyl (meth)acrylamide.

Examples of the glycidyl group-containing monomers include glycidyl (meth)acrylate and allyl glycidyl ether.

In addition, as the acrylic polyol, those obtained by copolymerizing monomers such as styrene, α-methyl styrene, vinyl methyl ether, vinyl ethyl ether, maleic acid, alkyl maleic acid monoester, fumaric acid, alkyl fumaric acid monoester, itaconic acid, alkylitaconic monoester, (meth)acrylonitrile, vinylidene chloride, ethylene, propylene, vinyl chloride, vinyl acetate, and butadiene can be used.

Here, the "(meth)acrylic acid" refers to either or both of an acrylic acid in which a hydrogen atom is bonded at the α-position and a methacrylic acid in which a methyl group is bonded at the α-position.
The "(meth)acrylic acid ester" refers to either or both of an acrylic acid ester in which a hydrogen atom is bonded at the α-position and a methacrylic acid ester in which a methyl group is bonded at the α-position.
The "(meth)acrylate" refers to either or both of an acrylate in which a hydrogen atom is bonded at the α-position position and a methacrylate in which a methyl group is bonded at the α-position.

In addition, in the invention, an isocyanate curable acrylic adhesive resin is included in the urethane-based resin.
In addition, various additives may be blended to the adhesive layer 13 as long as the additives do not deteriorate transparency, adhesiveness, weather resistance, and the like.
Examples of the additive include a coupling agent (a silane-based coupling agent or a metal-based coupling agent), an ultraviolet absorbing agent, an antioxidant, a filler, an anti-foaming agent, a thickening agent, a leveling agent, a hardening accelerator, a filling agent, an antigelling agent, a heat shield agent, and the like.

The thickness of the adhesive layer 13 is appropriately adjusted in accordance with the supporting base sheet 11 and the thermally fusible resin layer 12. For example, it is preferable that the thickness of the adhesive layer 13 be within a range of 1 to 25 µm. From the viewpoints of lightness, an electrical insulation property, and the like, it is more preferable that the thickness be within a range of 2 to 20 µm, and still more preferably within a range of 3 to 10 µm.

According to the transparent protective sheet 10, since the thermally fusible resin layer 12 is formed from a copolymer obtained by polymerizing ethylene and an unsaturated carboxylic acid as essential components, and a content ratio of a constituent unit derived from the unsaturated carboxylic acid is 5 to 30% by mass, it is possible to suppress generation of large spherulites in the thermally fusible resin layer 12 due to a heating treatment for integrating the laminated body including the solar cell, the sealing material, and the transparent protective sheet 10. Accordingly, a light scattering phenomenon in the thermally fusible resin layer 12 is suppressed, and thus an increase in haze is suppressed. Furthermore, it is possible to prevent transparency of the thermally fusible resin layer 12 from deteriorating. Specifically, it is possible to suppress the haze value after the heat treatment (150°C, 1 atm, and 15 minutes) of the transparent protective sheet 10 to 5% or less.

In addition, in this embodiment, the transparent protective sheet 10 in which the thermally fusible resin layer 12 is laminated on the one surface 11a of the supporting base sheet 11 through the adhesive layer 13 is exemplified, but the invention is not limited thereto. The thermally fusible resin layer 12 may be directly laminated on the one surface 11a of the supporting base sheet 11 without through the adhesive layer 13.

"Method of Manufacturing Transparent Protective Sheet"
Next, a method of manufacturing the transparent protective sheet 10 will be described with reference to FIG. 1.
A resin material that forms the thermally fusible resin layer 12 is melted and kneaded using a T die extruder and then a thermally fusible resin sheet making up the thermally fusible resin layer 12 having a predetermined thickness is molded. A temperature at which the resin material forming the thermally fusible resin layer 12 is melted is preferably 80 to 350°C, and more preferably 150 to 300°C.
Then, an adhesive is applied to the one surface 11a of the supporting base sheet 11 using a rod coater or the like to form the adhesive layer 13.
Then, a corona treatment is performed with respect to one surface of the thermally fusible resin making up the thermally fusible resin layer 12, and the thermally fusible resin sheet and the supporting base sheet 11 are laminated at a temperature of 20 to 120°C with this corona treated surface facing the adhesive layer 13. Then, the resultant laminated body is cured under an environment of 23°C and 50% RH for 4 to 7 days to obtain the transparent protective sheet 10.

### (2) Second Embodiment

FIG. 2 shows a schematic cross-sectional diagram illustrating a second embodiment of the transparent protective sheet of the invention.
In FIG. 2, the same reference numbers are given to the same constituent elements as the transparent protective sheet 10 shown in FIG. 1, and description thereof is omitted.
Similarly to the first embodiment, a transparent protective sheet 20 of this embodiment is applied to the front sheet or the back sheet of the solar cell module.

In the transparent protective sheet 20, in addition to the structure of the protective sheet 10 for the solar cell module of the first embodiment, a deposited layer 14 is further provided.
In this embodiment, a supporting base sheet 11, a thermally fusible resin layer 12, and an adhesive layer 13 have the same configuration as the first embodiment.

The deposited layer 14 is laminated on a surface (hereinafter, referred to as "one surface") 11a, on which the thermally fusible resin layer 12 is provided, of the supporting base sheet 11, and is interposed between the supporting base sheet 11 and the adhesive layer 13.

The deposited layer 14 is not particularly limited as long as the deposited layer 14 is formed from a metal and an inorganic material such as an oxide, a nitride, and a silicide of the metal, and is formed by deposition with respect to the supporting base sheet 11.
As a deposition method of forming the deposited layer 14, for example, a chemical vapor deposition method such as a plasma chemical vapor deposition method, a thermochemical vapor deposition method, and a photochemical vapor deposition method, and a physical vapor deposition method such as a vacuum deposition method, a sputtering method, and an ion plating method are used. Among these methods, the vacuum deposition method is preferable in consideration of operability or a layer thickness control property.

The deposited layer 14 functions as a humidity barrier layer having a water vapor barrier property. In addition, when the deposited layer 14 is applied to the solar cell module, weather resistance of the solar cell module may be increased.

Examples of the metal that is used include metals such as silicon (Si), aluminum (Al), magnesium (Mg), calcium (Ca), potassium (K), tin (Sn), sodium (Na), boron (B), titanium (Ti), lead (Pb), zirconium (Zr), and yttrium (Y).
Examples of the oxide, nitride, and oxynitride of the metal include a silicon oxide, an aluminum oxide, a tin oxide, a silicon nitride, a silicon oxynitride, an aluminum oxynitride, and the like.

The deposited layer 14 may be formed from one kind of inorganic material, or plural kinds of inorganic materials.
In a case where the deposited layer 14 is formed from plural kinds of inorganic material, the deposited layer 14 may be a deposited layer having a laminated structure in which a layer formed from each inorganic material is sequentially deposited, or a deposited layer in which plural kinds of inorganic materials are simultaneously deposited.

The thickness of the deposited layer 14 is appropriately set in consideration of a water vapor barrier property, and is changed in accordance with a kind or deposition density of the inorganic material that is used, and the like. It is preferable that the thickness of the deposited layer 14 be 5 to 200 nm, and more preferably 10 to 100 nm.

According to the transparent protective sheet 20, in addition to the configuration of the transparent protective sheet 10 of the embodiment, the deposited layer 14 is further provided to the supporting base sheet 11, and thus humidity resistance may be improved in addition to the effect of the transparent protective sheet 10.

In addition, in this embodiment, the transparent protective sheet 20 in which the deposited layer 14 is provided on the one surface 11a of the supporting base sheet 11 is exemplified, but the invention is not limited thereto. In the invention, the deposited layer may be provided on both surfaces (one surface and the other surface) of the supporting base sheet.

### (3) Third Embodiment

FIG. 3 shows a schematic cross-sectional diagram illustrating a third embodiment of the transparent protective sheet of the invention.
In FIG. 3, the same reference numerals are given to the same constituent elements as the transparent protective sheet 10 shown in FIG. 1 and the transparent protective sheet 20 shown in FIG. 2, and description thereof will be omitted.
Similarly to the first embodiment and the second embodiment, a transparent protective sheet 30 of the embodiment is applied to the front sheet or the back sheet of the solar cell module.

In the transparent protective sheet 30, in addition to the structure of the transparent protective sheet 20 of the second embodiment, a fluorine resin layer 15 is further provided.
In this embodiment, a supporting base sheet 11, a thermally fusible resin layer 12, and an adhesive layer 13 have the same configuration as the first embodiment, and the deposited layer 14 has the same configuration as the second embodiment.

The fluorine resin layer 15 is laminated on a surface (hereinafter, referred to as "the other surface") 11b, which is opposite to the surface on which the thermally fusible resin layer 12 is formed, of the supporting base sheet 11.

The thickness of the fluorine resin layer 15 is set in consideration of weather resistance, chemical resistance, lightness, and the like, and it is preferable that the thickness be within a range of 5 to 50 µm, and more preferably 10 to 30 µm.

The fluorine resin layer 15 is not particularly limited as long as the layer contains fluorine. As a layer obtained by forming the layer containing fluorine, for example, a sheet formed from a fluorine-containing resin, a film formed by applying a coating material including the fluorine-containing resin, and the like may be exemplified.

In a case where the fluorine resin layer 15 is the sheet formed from the fluorine-containing resin, the fluorine resin layer 15 is laminated on the other surface 11b of the supporting base sheet 11 through an adhesive layer 13'.
As an adhesive making up the adhesive layer 13', the same adhesive making up the adhesive layer 13 is used.

On the other hand, in a case of the fluorine resin layer 15 is a film formed by applying the coating material including the fluorine-containing resin, commonly, the fluorine resin layer 15 is laminated by directly applying the coating material including the fluorine-containing resin to the supporting base sheet 11 without through the adhesive layer.

As the sheet formed from the fluorine-containing resin, for example, a sheet, which is obtained by processing a resin containing polyvinyl fluoride (PVF), ethylene chlorotrifluoroethylene (ECTFE), or ethylene tetrafluoroethylene (ETFE) as a main component into a sheet shape, is used.
As the resin containing PVF as a main component, for example, "Tedlar (product name, manufactured by E. I. du Pont de Nemours and Company)" is used.
As the resin containing ECTFE as a main component, for example, "Halar (product name, manufactured by Solvay Solexis, Inc.)" is used.
As the resin containing ETFE as a main component, for example, "Fluon (product name, manufactured by Asahi Glass Co., Ltd.)"

The coating material including the fluorine-containing resin is not particularly limited as long as the resin is dissolved in a solvent or is dispersed in water, and is applicable.

The fluorine-containing resin that is included in the coating material is not particularly limited as long as the resin does not deteriorate the effect of the invention and the resin contains fluorine, and a resin is used which is dissolved in a solvent (an organic solvent or water) of the coating material and is cross-linkable.

Specifically, examples of a fluoroolefin resin include polymers such as "LUMIFLON (product name, manufactured by Asahi Glass Co., Ltd.)", "CEFRAL COAT (product name, manufactured by Central Glass Co., Ltd)", and "FLUONATE (product name, manufactured by DIC Co., Ltd.)" that contain chlorotrifluoroethylene (CTFE) as a main component, polymers such as "ZEFFLE (product name, manufactured by DAIKIN INDUSTRIES)" that contains tetrafluoroethylene (TFE) as a main component, and the like.

The "LUMIFLON" is a non-crystalline resin that contains CTFE, and various kinds of specified alkyl vinyl ether (VE) and hydroxyl alkyl vinyl ether as a main constituent unit. A resin including a monomer unit of hydroxyl alkyl vinyl ether like the "LUMIFLON" is excellent in solvent solubility, crosslinking reactivity, adhesion, stiffness, and flexibility, and thus this resin is preferable.
The "ZEFFLE" is a copolymer of TFE and hydrocarbon olefin having organic solvent solubility. A copolymer containing hydrocarbon olefin having a hydroxyl group having high reactivity is excellent in solvent solubility, crosslinking reactivity, adhesion, and pigment dispersibility, and thus this copolymer is preferable.

The coating material may include a crosslinking agent and a solvent in addition to the above-described fluorine-containing resin.

The crosslinking agent is not particularly limited as long as the crosslinking agent does not deteriorate the effect of the invention, and metal chelates, silanes, isocyanates, or melamines are appropriately used as the crosslinking agent.

The solvent is not particularly limited as long as the solvent does not deteriorate the effect of the invention. A solvent which contains any one kind or two kinds or more organic solvents selected from a group consisting of methyl ethyl ketone (MEK), cyclohexanone, acetone, methyl isobutyl ketone (MIBK), toluene, xylene, methanol, isopropanol, ethanol, heptane, ethyl acetate, isopropyl acetate, n-butyl acetate, and n-butyl alcohol is appropriately used.

As a method of applying the coating material to the other surface 11b of the supporting base sheet 11, a method known in the related art is used, for example, the coating material may be applied by a rod coater to have a desired thickness.
A drying temperature of the coating material that is applied to the other surface 11b of the supporting base sheet 11 may set to a temperature at which the effect of the invention does not deteriorate. From a viewpoint of reducing an effect to the supporting base sheet 11, it is preferable that the temperature be within a range of 50 to 130°C.

According to the transparent protective sheet 30, since the fluorine resin layer 15 is provided in addition to the configuration of the transparent protective sheet 20 of the second embodiment, in addition to the effect of the transparent protective sheet 20, weather resistance may be improved.

### (4) Fourth Embodiment

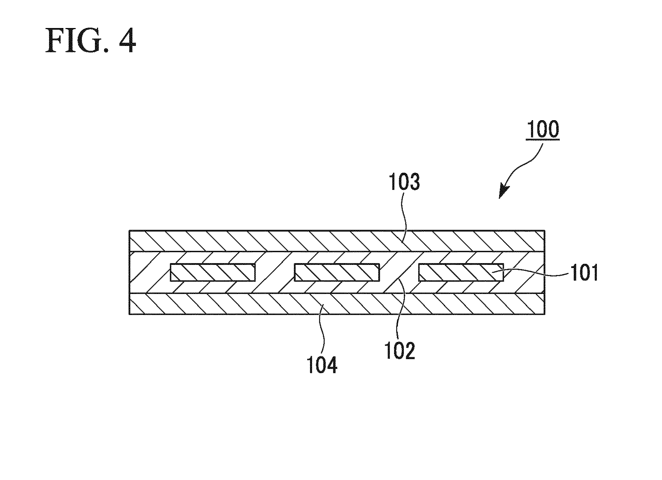

FIG. 4 shows a schematic cross-sectional diagram illustrating an embodiment of the solar cell module of the invention.
The solar cell module 100 schematically includes a solar cell 101 that is formed from crystalline silicon, amorphous silicon, or the like, a sealing material 102 that is formed from an electrical insulation body sealing the solar cell 101, a front surface protective sheet (front sheet) 103 that is laminated on a front surface of the sealing material 102, and a rear surface protective sheet (back sheet) 104 that is laminated on a rear surface of the sealing material 102.

In the solar cell module 100, the transparent protective sheet in any of the first to third embodiments is used as any one of the front sheet 103 and the back sheet 104.

In this embodiment, it is preferable that a resin making up the sealing material 102 be a polyolefin-based resin.
As the polyolefin-based resin, polyethylene such as low-density polyethylene (LDPE, density is equal to or more than 0.910 g/cm³ and less than 0.930 g/cm³), medium-density polyethylene (MDPE, density is equal to or more than 0.930 g/cm³ and less than 0.942 g/cm³), and high-density polyethylene (HDPE, density is equal to or more than 0.942 g/cm³), polypropylene (PP), olefin-based elastomer (TPO), cycloolefin-based resin, ethylene-vinyl acetate copolymer (EVA), ethylene-vinyl acetate-maleic anhydride copolymer, ethylene-(meth)acrylic acid copolymer, ethylene-(meth)acrylic acid ester-maleic anhydride copolymer, or the like is used.
According to this configuration, affinity between the thermally fusible resin layer 12 of the transparent protective sheet in any of the first to third embodiments and the sealing material 102 becomes large, and thus large adhesive strength between the thermally fusible resin layer 12 and the sealing material 102 may be obtained.

When the solar cell module is configured by applying the transparent protective sheet in any of the first to third embodiments to the front sheet or the back sheet, a solar cell module having the above-described effect may be obtained.

### (5) Fifth Embodiment

In a solar cell module 100 of this embodiment, the transparent protective sheet in any of the first to third embodiments is used to both front sheet 103 and back sheet 104.

In this embodiment, it is also preferable that the resin making up the sealing material 102 be a polyolefin-based resin.

When the solar cell module is configured by applying the transparent protective sheet in any of the first to third embodiments to the front sheet and the back sheet of the solar cell module, a solar cell module having high photoelectric conversion efficiency may be obtained.
Furthermore, when a flexible substrate is used in the solar cell making up the solar cell module, and the transparent protective sheet in any of the first to third embodiments is provided as the front sheet and the back sheet, a solar cell module having flexibility may be obtained. In this manner, when the solar cell module is made to have flexibility, mass production by roll to roll manner is realized. In addition, the solar cell module having flexibility may be fitted to an object having an arch-shaped or parabolic wall surface, and thus the solar cell module may be provided to a dome-shaped architectural structure, a soundproof wall of a highway, and the like.

### Examples

Hereinafter, the invention will be described in more detail with reference to examples and comparative examples, but the invention is not limited to the following examples.

### (Preparing of Adhesive)

11.1 parts by mass of xylene diisocyanate (product name: TAKENATE A-50, a solid content is 75%, manufactured by Mitsui Chemicals, Inc.) and 289.2 parts by mass of toluene were added to 100 parts by mass of polyester polyol (product name: TAKELAC A-515, a solid component is 60%, manufactured by Mitsui Chemicals, Inc.), and these were mixed with each other, whereby an adhesive was prepared.

### (Example 1)

The adhesive was applied to one surface of a PET film (product name: Cosmoshine A4100, thickness is 125 µm, manufactured by TOYOBO CO., LTD.) using a rod coater, and the applied adhesive was dried at 80°C for one minute, whereby an adhesive layer having a thickness of 5 µm was formed.
In addition, a corona treatment was performed with respect to one surface of a sheet formed from an ethylene-methacrylic acid copolymer (with an acid content ratio of 15%) and having a thickness of 100 µm, and the ethylene-methacrylic acid copolymer sheet was laminated toward the one surface of the PET film at a temperature of 40°C with the corona-treated surface facing the adhesive layer formed on the one surface of the PET film, and then the resultant laminated body was cured under an environment of 23°C and 50% RH for 7 days, whereby an transparent protective sheet of Example 1 was obtained.

### (Example 2)

A transparent protective sheet of Example 2 was prepared in the same manner as Example 1 except that a sheet formed from ethylene-methacrylic acid copolymer with an acid content ratio of 12% was used.

### (Example 3)

A transparent protective sheet of Example 3 was prepared in the same manner as Example 1 except that a sheet formed from ethylene-methacrylic acid copolymer with an acid content ratio of 9% was used.

### (Example 4)

A transparent protective sheet of Example 4 was prepared by forming an adhesive layer having a thickness of 5 µm on the PET film surface of the transparent protective sheet prepared in Example 1 similarly to Example 1, and by laminating an ETFE film (product name: Fluon ETFE Film 25 N, manufactured by Asahi Glass Co., Ltd.) having a thickness of 25 µm on the adhesive layer at a temperature of 40°C.

### (Comparative Example 1)

A transparent protective sheet of Comparative Example 1 was prepared in the same manner as Example 1 except that a sheet formed from ethylene-methacrylic acid copolymer with an acid content ratio of 4% was used.

### (Comparative Example 2)

A transparent protective sheet of Comparative Example 2 was prepared in the same manner as Example 1 except that a sheet formed from an ethylene-vinyl acetate copolymer (with a vinyl acetate content ratio of 9%) was used instead of ethylene-methacrylic acid copolymer.

### (Comparative Example 3)

A transparent protective sheet of Comparative Example 3 was prepared in the same manner as Example 1 except that a sheet formed from a polyethylene resin was used instead of ethylene-methacrylic acid copolymer.

### (Evaluation Method and Evaluation Result)

### (Preparing of Evaluation Sheet)

The thermally fusible resin layer of the transparent protective sheet manufactured in each of the examples and comparative examples was overlapped on one surface of a white plate reinforced glass (a reinforced glass having a low iron content) (manufactured by AGC Fabritech Co., Ltd.) having a thickness of 3 mm with the resin layer facing a glass surface, and then the resultant overlapped body was heated under conditions of a pressure of 1 atm and a temperature of 150°C for 15 minutes using a vacuum chamber, whereby evaluation sheets were prepared.

### (Measurement of Transmittance)

Light was emitted from the transparent protective sheet side of each of the evaluation sheets, and a spectral transmittance of a wavelength of 400 to 1,200 nm was measured, and then an arithmetic mean value thereof was obtained.
For the measurement of the spectral transmittance, a spectrophotometer (device name: UV-3600, manufactured by Shimadzu Corporation) was used.
Results are shown in Table 1.

### (Measurement of Haze)

Light was emitted from the transparent protective sheet side of each of the evaluation sheets, and haze was measured.
The haze was measured in accordance with JIS K7136: 2000 (ISO14782: 1999) using a hazemeter (device name: NDH-5000, manufactured by NIPPON DENSHOKU INDUSTRIES CO., LTD.).
Results are shown in Table 1.

**[Table 1]**

| | Transmittance (%) | Haze (%) |
|---|---|---|
| Example 1 | 86 | 1.6 |
| Example 2 | 85 | 1.9 |
| Example 3 | 85 | 2.0 |
| Example 4 | 83 | 4.5 |
| Comparative Example 1 | 87 | 17.4 |
| Comparative Example 2 | 82 | 14.3 |
| Comparative Example 3 | 82 | 12.7 |

From Table 1, it was confirmed that in the transparent protective sheets of Examples 1 to 4, transmittance after the heating treatment was 83% or more, and the haze value after the heating treatment was 4.5% or less, and thus the transmittance and the haze were superior to Comparative Examples 1 to 3.

### Industrial Applicability

The transparent protective sheet of the invention is applicable to the front sheet or the back sheet of the solar cell module.

### Reference Signs List

10, 20, 30: Transparent protective sheet
11: Supporting base sheet
12: Thermally fusible resin layer
13, 13': Adhesive layer
14: Deposited layer
15: Fluorine resin layer
100: Solar cell module
101: Solar cell
102: Sealing material
103: Front surface protective sheet (front sheet)
104: Rear surface protective sheet (back sheet)

## Claims

1. A transparent protective sheet, comprising:
a supporting base sheet; and
a thermally fusible resin layer that is laminated on at least one surface of the supporting base sheet,
wherein the thermally fusible resin layer is formed from a copolymer obtained by polymerizing ethylene and an unsaturated carboxylic acid as essential components, and a content ratio of a constituent unit derived from the unsaturated carboxylic acid is 5 to 30% by mass.

2. The transparent protective sheet according to claim 1,
wherein a haze value after the heating treatment is 5% or less.

3. The transparent protective sheet according to claim 1 or 2,
wherein the unsaturated carboxylic acid is an acrylic acid or methacrylic acid.

4. The transparent protective sheet according to any one of claims 1 to 3,
where a thickness of the thermally fusible resin layer is within a range of 1 to 200 µm.

5. The transparent protective sheet according to any one of claims 1 to 4, further comprising:
a deposited layer,
wherein the deposited layer is laminated on the surface of the supporting base sheet on which the thermally fusible resin layer is provided.

6. The transparent protective sheet according to any one of claims 1 to 5, further comprising:
a fluorine resin layer,
wherein the fluorine resin layer is laminated on a surface opposite to the surface of the supporting base sheet on which the thermally fusible resin layer is formed.

7. A solar cell module, comprising:
a solar cell;
a sealing material that seals the solar cell; and
a transparent protective sheet that is laminated on the sealing material,
wherein the transparent protective sheet is formed from the transparent protective sheet according to any one of claims 1 to 6, and
the transparent protective sheet is laminated on the sealing material through the thermally fusible resin layer.
